# EUROPÄISCHE PATENTANMELDUNG

(11) **EP 2 421 053 A2**
(43) Veröffentlichungstag der Anmeldung: **22.02.2012**
(21) Anmeldenummer: 11005838.5
(22) Anmeldetag: 16.07.2011
(51) Int. Cl.: H01L 31/042

(54) **Himmelsrichtungsverdrehter Freiflächenphotovoltaikgenerator**

(30) Priorität: 20.08.2010 DE 102010035000
(71) Anmelder: Adensis GmbH, 01129 Dresden (DE)
(72) Erfinder: Beck, Bernhard, 97509 Kolitzheim (DE)

(57) **Zusammenfassung**

Es wird ein Photovoltaik-Freiflächengenerator vorgestellt,der aus einer Mehrzahl von geraden, parallel zueinander verlaufenden Reihen (9) von auf einer Unterkonstruktion angeordneten, rechteckförmigen Photovoltaikmodulen (11) besteht, die jeweils eine Vielzahl von Photovoltaikzellen (19:21) umfassen. Die Photovoltaikzellen sind so auf jedem Photovoltaikmodul angeordnet sind, dass bei einer parallel zu einem Rand des Photovoltaikmoduls verlaufenden Abschattung die Energieumwandlungs und - transportfunktion der übrigen, nicht abgeschatteten Photovoltaikzellen oder Photovoltaikzellenbereiche des Photovoltaikmoduls erhalten bleibt. Die Unterkonstruktion sorgt für eine gleiche Neigung (α) der Photovoltaikmodule gegen Süden. Die Reihen bezüglich der Ost-West Richtung sind in einem Winkel (β) zwischen 10° und 40° in Richtung Nordost oder in Richtung Nordwest verdreht aufgestellt sind. Die Anordnung erlaubt unter Inkaufnahme einer, über den Tagesverlauf gesehen, reduzierten Gesamtleistung der photovoltaisch erzeugten Energie eine Verschiebung des Leistungsmaximums zu einer anderen Uhrzeit als 12.00 Uhr mittags.

## Beschreibung

Die Erfindung bezieht sich auf einen Freiflächenphotovoltaikgenerator mit einer Mehrzahl von geraden, parallel zueinander verlaufenden Reihen von rechteckförmigen Photovoltaikmodulen die auf einer fest stehenden Unter-konstruktion stationär angeordnet sind und jeweils einen einzigen Strang von in Serie geschalteter Photovoltaikzellen umfassen, sowie auf eine entsprechen-den Generator mit mehreren Strängen von in Serie geschalteter Photovoltaikzellen (19;21), deren Enden einen ersten und einen zweiten Ausgangspol des Photovoltaikmoduls bilden. Die Erfindung bezieht sich weiterhin auf die oben genannten Freiflächenphotovoltaikgeneratoren, bei denen die Reihen Zwischenräume aufweisen, so dass innerhalb jeder Reihe aus Gruppen von Photovotaikmodulen besteht.

Solche Freiflächenanlagen sind sattsam bekannt. Dabei wird unter einem Freiflächengenerator eine Anlage verstanden, die keine Schutzfunktion gegen Witterung ausübt, wie z.B. Dachanlagen, und die entsprechend für Regenwasser durchlässig ist, um unter ihr befindlichen Erdboden nicht zu versiegeln. Alle der Anmelderin bekannten Anlagen dieser Art sind, soweit es das Gelände zulässt, so ausgerichtet, dass die Reihen von Photovoltaik-modulen, im folgenden auch PV-Module genannt, in Ost-West Richtung verlaufen und die Normale zur Moduloberfläche gen Süden gerichtet ist. Die Neigung der Module zur Horizontalen wiederum ist unterschiedlich je nach Aufstellungsort des PV-Generators. Diese Aufstellung erlaubt es, integriert über den Tag gesehen, die Erzeugung der maximalen Energiemenge unter den gegebenen Wetterverhältnissen. Jedes Verdrehen der Reihen aus der Ost-West Achse heraus (entsprechend einer Orientierung der Photovoltaikmodule aus der Südrichtung heraus) würde zu einer Minderleistung führen, die sich zum einen aus der insgesamt gesehen ungünstigeren Ausrichtung der PV-Module zur Sonne ergibt und zum anderen daher, dass bei einem frühen tiefen Sonnenstand die PV-Module von ihrer Rück- oder Unterseite angestrahlt werden und bei einem späten, tiefen Sonnenstand eine Abschattung derart erfolgt, dass der obere Rand der geneigten Photovoltaikmodule den unteren Rand einer dahinter angeordneten Reihe verdecken würde.

Diese Verschattung hat bei Verwendung der klassischen Photovoltaikmodule mit einer Matrix von einer Vielzahl in Reihe geschalteter Photvoltaikzellen, die mäanderförmig auf der Moduloberfläche verlaufen, den Nachteil, dass die Verdunkelung den elektrischen Widerstand der verschatteten Zellen erhöht, was bis zu einem Erliegen des photovoltaisch erzeugten Gleichstroms führen kann. Durch die Reihenschaltung der Photozellen beeinflusst bereits eine einzige nichtleitende Zelle den Stromfluss des gesamten Strangs an Zellen. So führt auch ein einziges Laubblatt, welches eine der Photovoltaikzellen komplett verdeckt zu einem Ausfall des gesamten PV-Moduls.

Jüngere Entwicklungen in der Modultechnologie haben zu einem Photovoltaikmodul geführt, bei dem die einzelnen Zellen über die gesamte Kantenlänge des PV-Moduls von Rand zu Rand des PV-Moduls verlaufen. Wird bei einem solchen Modul jede Zelle ein Stückweit abgeschattet, so kommt es lediglich zu einem Ausfall an erzeugter Energie entsprechend dem betroffenen Areal der Abschattung und nicht zu einem Komplettausfall.

Vorliegende Erfindung geht von der Überlegung aus, dass es in Ländern mit heißen klimatischen Gegebenheiten der Fall ist, dass der Zeitraum der höchsten Erwärmung von Gebäudeinnenräumen erst am Nachmittag auftritt. Entsprechend ist die Energieanforderung seitens der Klimageräte nicht um 12.00 Uhr beim höchsten Sonnenstand am höchsten, sondern erst später gegen z.B. 15.00 Uhr. Da die Klimageräte einen hohen Anteil des gesamten Energieverbrauchs darstellen, ist der Bezug von elektrischer Energie deswegen am Nachmittag teurer im Vergleich zum Vormittag. Entsprechend ist auch die Vergütung, die Energieversorger für erzeugten Strom bereit sind zu zahlen, in den Hochlastzeiten höher als in Schwachlastzeiten. Die nachstehend abgebildete Tabelle zeigt ein Beispiel einer tatsächlichen Tarifgestaltung eines Energieversorgers in den USA.

**Tabelle 1: Vergütungstarife für Solarstrom in Abhängigkeit der Tageszeit**

| **Time of Delivery** | **Months** | **Super Peak** | **On Peak** | **Off Peak** |
|---|---|---|---|---|
| **Summer** | June - Sept | 2:00 to 8:00 pm | 6:00 am to 2:00 pm | |
| | | Mon - Sat | 8:00 pm to 10:00 pm | all other hours |
| | | except holidays | Mon - Sat except holidays | |
| **Fall & Winter** | Oct. - Feb | | | |
| **Spring** | Mar - May | | | |
| **Holidays** | New Years, July 4th, Memorial Day, Labor Day, Thanksgiving, Christmas | | | |

| **Time of Use Period** | **10-Year** |
|---|---|
| **Winter Off Peak** | $ 0,0731 |
| **Winter ON Peak** | $ 0,0916 |
| **Winter Super Peak** | $ 0,1103 |
| **Spring Off Peak** | $ 0,0628 |
| **Spirng On Peak** | $ 0,0751 |
| **Spring Super Peak** | $ 0,0836 |
| **Summer Off Peak** | $ 0,0793 |
| **Summer On Peak** | $ 0,0875 |
| **Summer Super Peak** | $ 0,2951 |
| **Annual Average** | $ 0,1065 |

Der Erfindung liegt daher die Aufgabe zugrunde, die Einspeisung photovoltaisch erzeugter Energie bei Freiflächenanlagen ohne Sonnenstands-nachführung so zu gestalten, dass eine Optimierung der Vergütung seitens des Energieversorgers möglich ist.

Diese Aufgabe wird bei Vorliegen von Photovoltaikmodulen mit einem einzigen Strang erfindungsgemäß dadurch gelöst, dass die Photovoltaikzellen so auf jedem Photovoltaikmodul angeordnet sind, dass bei einer parallel zum unteren Rand des Photovoltaikmoduls verlaufenden Abschattung jede Photovoltaikzelle des Strangs die gleiche Abschattung erfährt, dass die Unterkonstruktion eine gleiche Neigung α aller Photovoltaikmodule zur Horizontalen bereitstellt und dass die Photovoltaikmodule in einem Winkel β zwischen 10° und 40° in Richtung Südwest oder in Richtung Südost orientiert sind. Bei Vorliegen von Photovoltaikmodulen mit mehreren Strängen wird die Aufgabe dadurch gelöst, dass die Photovoltaikzellen so auf jedem Photovoltaikmodul angeordnet sind, dass bei einer parallel zum unteren Rand des Photovoltaikmoduls verlaufenden Abschattung jede Photovoltaikzelle des Strangs die gleiche Abschattung erfährt, dass die Unterkonstruktion eine gleiche Neigung α aller Photovoltaik-module zur Horizontalen bereitstellt und dass die Photovoltaikmodule in einem Winkel β zwischen 10° und 40° in Richtung Südwest oder in Richtung Südost orientiert sind. Bei Vorliegen eines oder mehrerer Zwischenräume zwischen PV-Modulen einer Reihe wird die Aufgabe bezüglich des ersten Modultyps dadurch gelöst, dass die Photovoltaikzellen so auf jedem Photovoltaikmodul angeordnet sind, dass zumindest bei einem Teil der Photovoltaikmodule einer Gruppe bei einer parallel zum unteren Rand des Photovoltaikmoduls verlaufenden Abschattung jede Photovoltaikzelle des Strangs die gleiche Abschattung erfährt, dass die Unterkonstruktion eine gleiche Neigung (α) aller Photovoltaikmodule zur Horizontalen bereitstellt und dass die Photovoltaikmodule in einem Winkel (β) zwischen 10° und 40° in Richtung Südwest oder in Richtung Südost orientiert sind und bezüglich des zweiten Modultyps dadurch, dass die Photovoltaikzellen so auf jedem Photovoltaik-modul angeordnet sind, dass bei einer parallel zum unteren Rand des Photovoltaikmoduls verlaufenden Abschattung bei zumindest einem Teil der Photovoltaikmodule derselben Gruppe alle Photovoltaikzellen desselben Stranges die gleiche Abschattung erfahren, dass die Unterkonstruktion eine gleiche Neigung (α) aller Photovoltaikmodule zur Horizontalen bereitstellt und dass die Photovoltaikmodule in einem Winkel (β) zwischen 10° und 40° in Richtung Südwest oder in Richtung Südost orientiert sind.

Dabei wird unter einer Reihe jegliche Anordnung von PV-Modulen in einer sich längs erstreckenden planen Fläche verstanden. Die Eigenschaft eben oder planar gilt nicht mathematisch, sondern kann eine gewisse Biegung in Anpassung an das Gelände umfassen. Die Reihe kann sowohl fortlaufend ohne Unterbrechungen sein, als auch Zwischenräume aufweisen, was einer Aufteilung einer Reihe in Teilstrecken oder Gruppen gleichkommt. Minimale montagebedingte Abstände von wenigen Milli- oder Zentimeter sollen dabei nicht als Unterbrechung oder Zwischenraum gelten.

Mit dem Hintergrundwissen der oben geschilderten, neuen Technologie zur Photovoltaikzelle hat diese gezielte Fehlausrichtung der Freiflächenanlage nicht mehr die Folge einer dramatischen Minderleistung zu den Zeiten der Sonnenstände, an denen eine durch die Schrägstellung und Fehlausrichtung gen Süden bedingte Abschattung eines Teils des PV-Moduls vorliegt. Dabei wird davon ausgegangen, dass die parallel zur Kante oder zum Rand des PV-Moduls verlaufende Abschattung über die gesamte Breite des PV-Moduls reicht. Dieses ist bei allen PV-Modulen der Reihe der Fall, bis jeweils auf das erste bzw. je nach Betrachtungsrichtung das letzte PV-Modul der Reihe. Dann wird eines der beiden PV-Module mit einer nicht über die gesamte Breite verlaufenden Abschattung belegt, was dann ebenfalls zu einer Minderleistung des am Reihenanfang bzw. Reihenendes liegenden PV-Moduls führt.

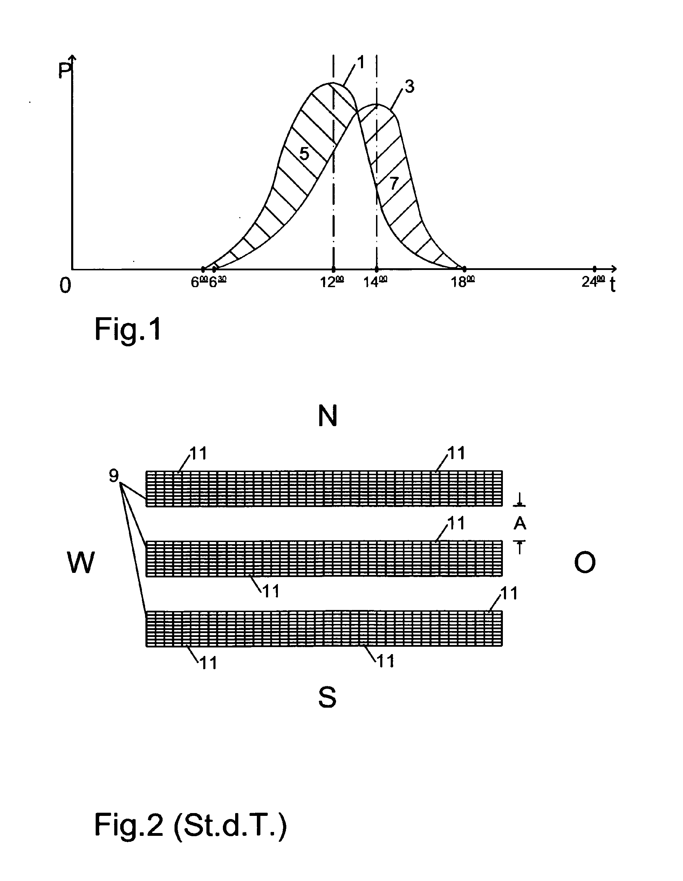

Der gewünschte Effekt wird anhand der Figur 1 im Folgenden näher erläutert. In der Figur 1 ist die photovoltaisch erzeugte Energie E über den Tagesverlauf t aufgetragen. Der Einfachheit halber wird dabei ein Zeitraum zwischen 6.00 Uhr in der Früh und 18.00 am Abend betrachtet. Um 12.00 Uhr steht die Sonne am höchsten und der PV-Generator liefert seine maximale Leistung. Der Verlauf der Leistung bzw. gelieferten Energie E ist durch eine Linie 1 dünner Strichstärke eingezeichnet. Links und rechts des Maximums verläuft die Kurve weitgehend symmetrisch nach einer Gaussverteilung.

Ein Verdrehen des PV-Generators um z.B. 30° in Richtung Nordost bewirkt, dass bei einem tiefen Sonnenstand in der früh um 6.00 Uhr zunächst nur die Rückseite der PV-Module angestrahlt wird und erst später gegen z.B. 06.30 Uhr die Oberseite der PV-Module ausreichend Sonnenenergie aufnimmt, um mit der Netzeinspeisung zu beginnen. Dieser Effekt ist in dem Kurvenverlauf entlang der dick eingezeichneten Linie 3 wiedergegeben, indem die Einspeisung später einsetzt. Die Linie 3 macht ebenfalls deutlich, dass die Energieausbeute zu Beginn aufgrund des verschlechterten Winkels zwischen den Moduloberflächen und der Sonne auch geringer ausfallen wird, als ohne die Verdrehung. Der weitere Kurvenverlauf der Linie 3 zeigt, dass aufgrund der Drehung um 30° sich aus Sicht des PV-Generators die maximale Einstrahlleistung um drei Stunden auf 15.00 Uhr verschiebt, wo die Kurve oder Linie 3 ihr Maximum erreicht. In der Abendstunde setzt der Effekt ein, dass eine Abschattung des unteren Randes einer jeden (bis auf die westliche) PV-Modulreihe durch den oberen Rand der westlich benachbarten PV-Modulreihe erfolgt. Die Einstrahlleistung wird dennoch immer oberhalb von der der Kurve 1 liegen, da der durch die Abschattung hervorgerufene Verlust an wirksamer Modulfläche durch den günstigeren Winkel der PV-Module zur Sonne mit der einhergehenden höheren Auftreffenergie auf der verbleibenden Modulfläche überkompensiert wird.

In der Figur 1 ist noch ein dünn schraffierter, erster Bereich 5 gezeigt, dessen Flächeinhalt dem Integral der Minderleistung über die Zeit t entspricht. Die Minderleistung entsteht durch die ungünstigere Ausrichtung der PV-Generatorreihen zur Sonne während des Vormittags aufgrund der Verdrehung und des späteren Einsetzens der Energieerzeugung. Im Gegenzug sind die PV-Generatorreihen am Nachmittag günstiger zur Sonne ausgerichtet als ohne die 30° Verdrehung, wodurch eine Energiemehrgewinnung im Vergleich zur üblichen Ost-West Ausrichtung anfällt. Die Größe dieses Mehrgewinns am Nachmittag ist durch einen zweiten, mit dicken Linien schraffierten Bereich 7 veranschaulicht. Es ist erkennbar, dass der erste Bereich 5 einen größeren Flächeninhalt aufweist als der zweite Bereich 7. Die Differenz zwischen beiden Bereichen 5,7 entspricht der insgesamt weniger produzierten Energie E des PV-Generators. Dieses weniger an Energie E wird aber aus wirtschaftlicher Sicht kompensiert, durch den höheren Ertrag der am Nachmittag gelieferten Energie im Vergleich zu der am Vormittag gelieferten Energie. In der zusammenschauenden Betrachtung wird also durch den höheren Energiepreis am Nachmittag mehr eingenommen, als durch die Minderlieferung am Vormittag an Einnahmeausfall anfällt.
Weitere Vorteile und Ausgestaltungen der Erfindung ergeben sich aus der Beschreibung eines Ausführungsbeispiels anhand der Figuren. Es zeigen:
- Fig. 1: ein Verlaufsdiagramm photovoltaisch erzeugter Leistung über den Tag;
- Fig. 2: eine schematische Aufsicht auf drei PV-Modulreihen in der klassischen Ost-West Orientierung;
- Fig. 3a-3e: eine schematisierte Seitenansicht zur Figur 2 zu verschiedenen Tageszeiten;
- Fig. 4: eine schematische Aufsicht auf drei um 30 ° gedrehte PV-Modulreihen;
- Fig.5a-5e: eine schematisierte Seitenansicht zur Figur 4 zu verschiedenen Tageszeiten;
- Fig. 6a-6c: verschiede PV-Modultypen, geeignet zum Einsatz in einer verdrehten Photovoltaikanlage; und
- Fig. 7: eine Ausführung mit Zwischenräumen innerhalb einer Modulreihe.

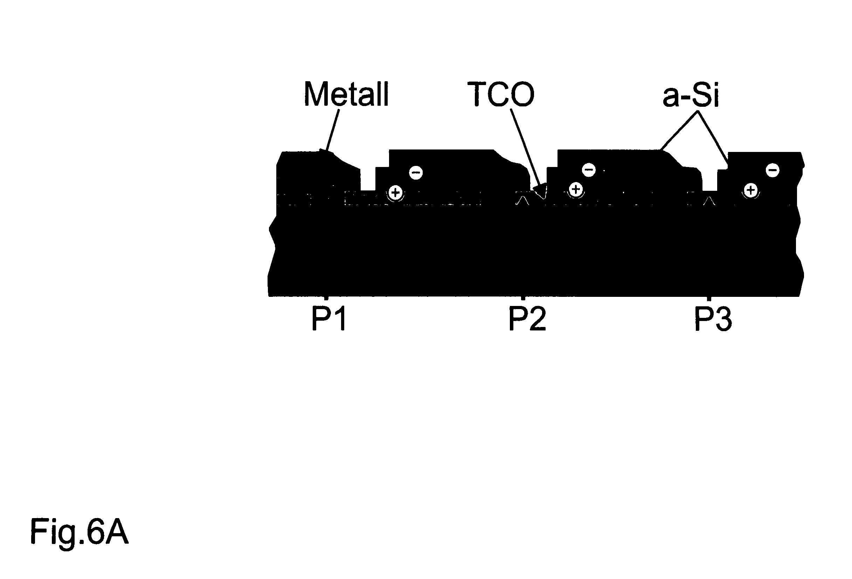

In der Figur 2 sind drei Reihen 9 von Photovoltaikmodulen 11 einer Freiflächen-anlage gezeigt, die in der üblichen Weise entlang der Ost-West Achse verlaufen. Jede Reihe kann bis zu mehrere Hundert Meter lang sein und Tausende von PV-Modulen 11 eines Typs aufweisen, wie er später anhand der Figuren 6a bis 6d beschrieben wird. Die PV-Module 11 sind um einen Winkel α gegen Süden geneigt, wobei die Neigung je nach Aufstellungsort variiert. Hier in mitteleuropäischen Gebieten beträgt die Neigung ca. 25°. Der Winkel α definiert den Auftreffwinkel der Sonnenstrahlen auf die PV-Module und ist in der Regel so gewählt, dass die Sonnenstrahlen am höchsten Sonnenstand um 12.00 senkrecht auf die Modulflächen auftreffen.

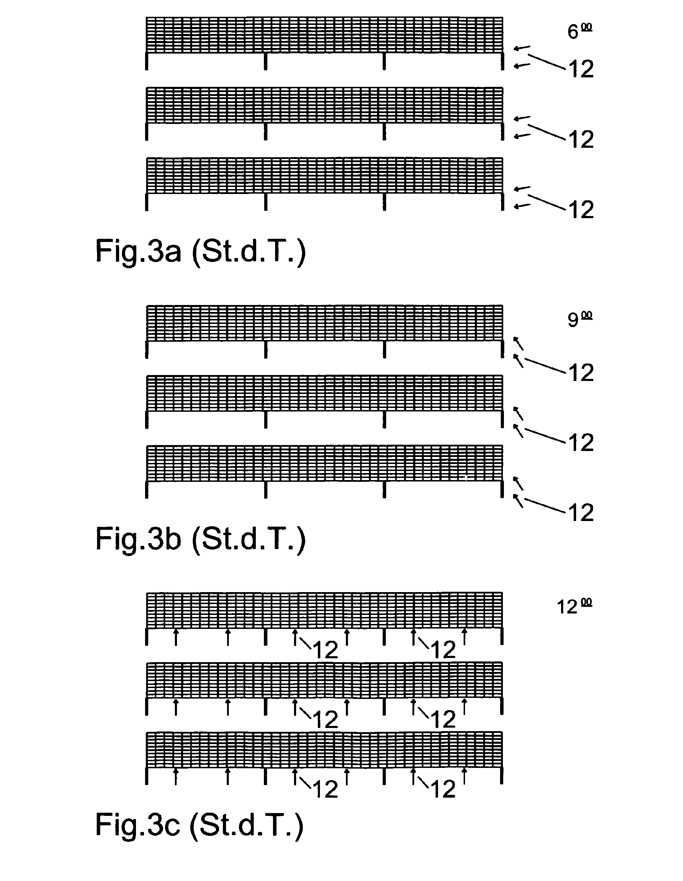

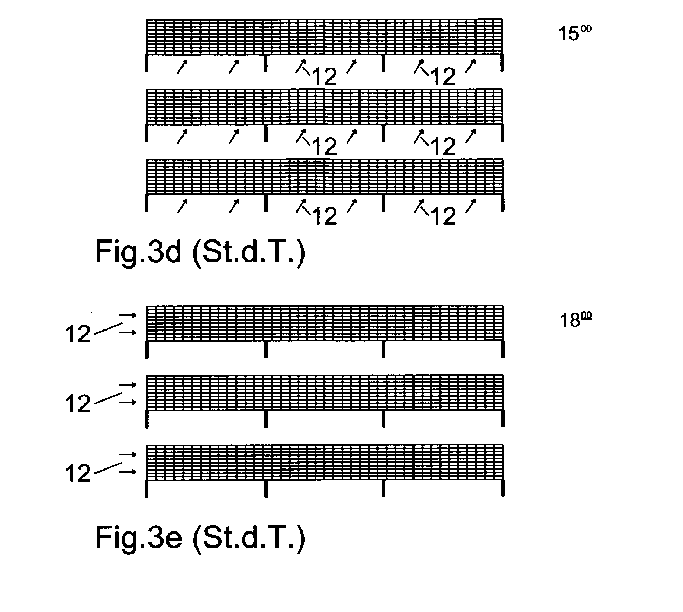

Die Figuren 3a bis 3e sind Seitenansichten der drei Reihen 9 zu unterschiedlichen Sonnenständen. Dabei ist durch Pfeile 13 nur der Richtungsvektor gezeigt, der den Komponenten der Strahlung parallel zur Blattebene entspricht. Die flachen Pfeile 13 der Figur 3a weisen dementsprechend um 06.00 Uhr in der Früh nur eine geringe Nord-Süd Komponente, aber eine relativ große Ost-West Komponente auf. Gegen 9.00 Uhr ist die Sonne soweit gewandert, dass ihre Strahlen steiler auf die Photovoltaikmodule auftreffen. Der Auftreffwinkel verbessert sich kontinuierlich mit höher stehender Sonne, bis um12.00 Uhr mittags die Pfeile ausschließlich in Nord-Süd Richtung weisen und die Strahlen senkrecht auf die Module auftreffen. Die nicht dargestellte dritte Komponente des an sich räumlichen Vektors 13 würde dem Sonnenstand entsprechen, der morgens und abends niedrig und mittags am höchsten ist. Nach Überschreiten des Zenits werden die Strahlen wieder flacher auf die PV-Module auftreffen, allerdings dann aus der Westrichtung. Dies ist anhand der Figur 3d gezeigt, die einen geschätzten Sonnenstand gegen 15.00 darstellt. Bei untergehender Sonne um 18.00 Uhr nach der Figur 3e treffen die Sonnenstrahlen wieder unter einem flachen Winkel aus Westen auf die Module. Die in den Figuren 2 und 3 symbolhaft dargestellte PV-Anlagenorientierung ermöglicht die maximal aus der Anlage herauszuholende Leistung unter den gegebenen Wetterver-hältnissen: Es treten keine konstruktiv bedingten Abschattungen auf und die Ausrichtung ist optimiert.

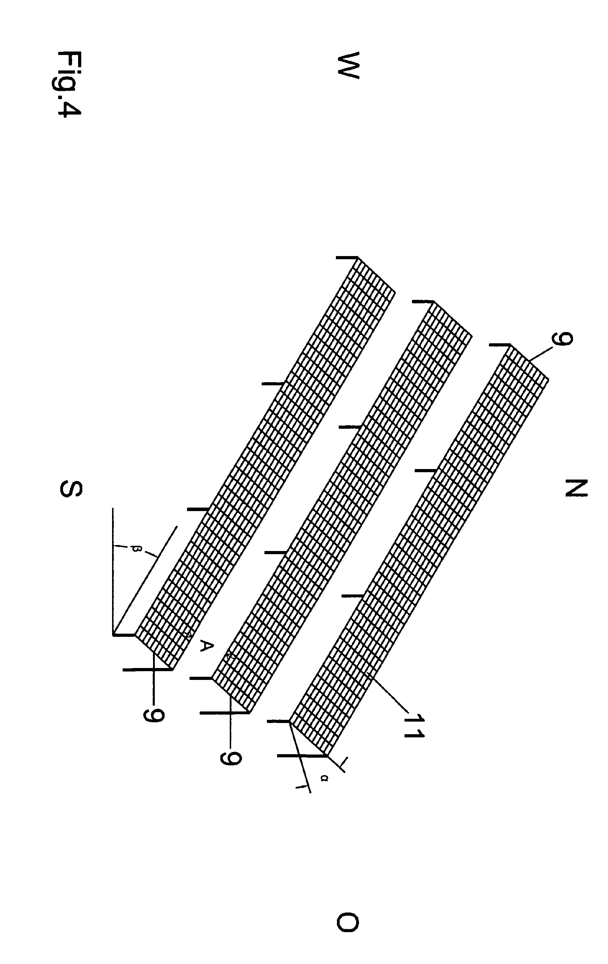

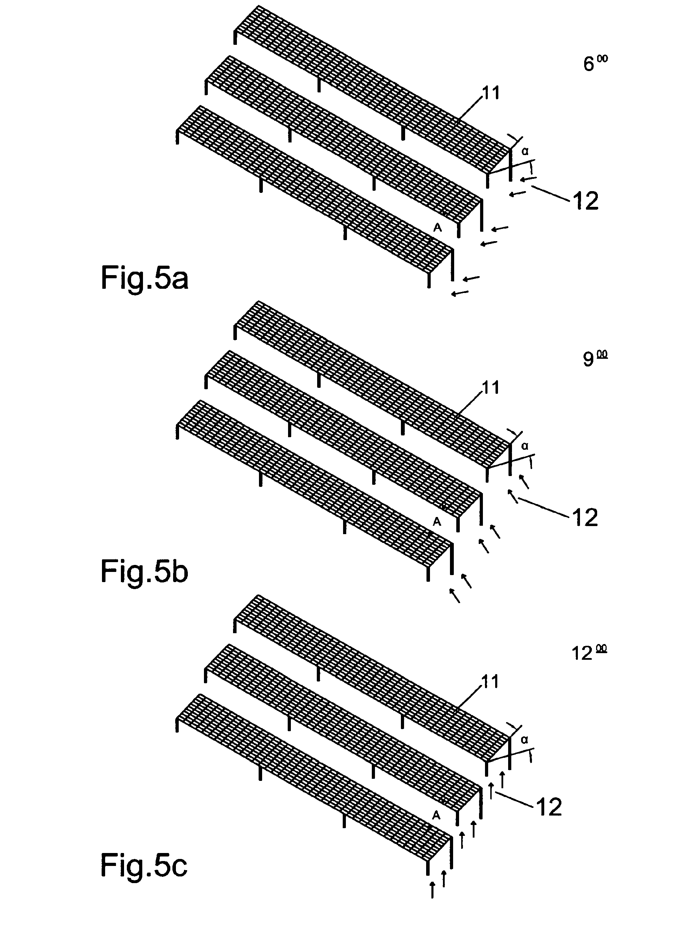

In der Figur 4 ist eine von der klassischen Orientierung abweichende Auf-stellung der PV-Reihen 9 gezeigt. Die Reihen 9 sind um 30° in Richtung Nord-Ost gedreht, wodurch die montierten PV-Module 11 ebenfalls ihre Orientierung gen Süden um 30° verlieren. Dadurch wird insgesamt weniger Sonnenenergie auf die Moduloberflächen auftreffen, wie es anhand der Figuren 5a bis 5e ersichtlich ist.

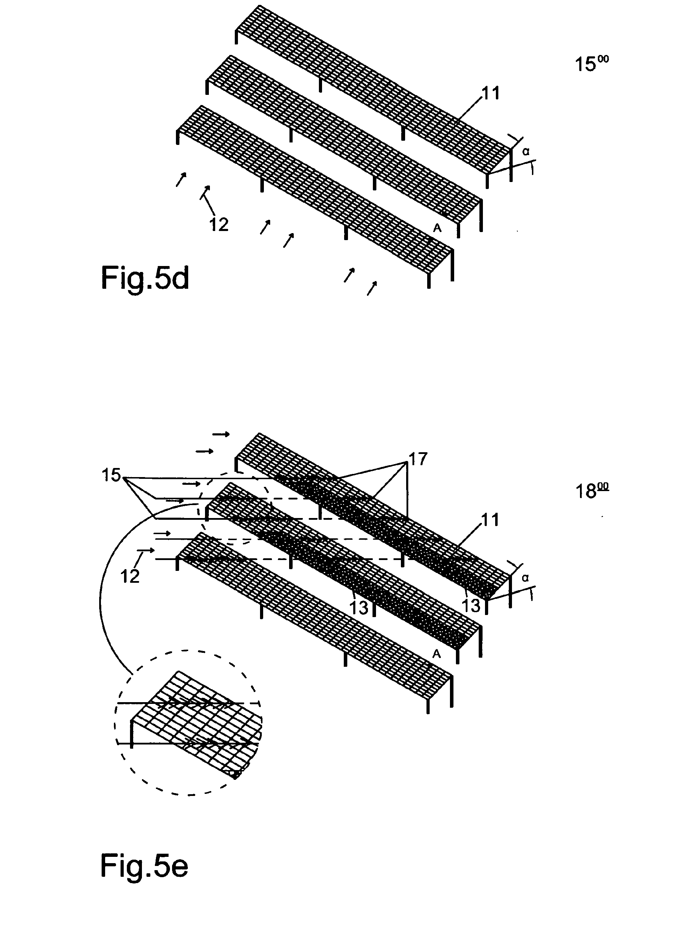

Aus der Figur 5a ist ersichtlich, dass nach Sonnenaufgang im Osten zunächst die Rückseite der PV-Module 11 angestrahlt wird. Ein Auftreffen auf die Moduloberfläche wird sich daher zeitlich verzögern. Bei der Figur 5b ist ein Sonneneinfall auf alle Modulflächen vorhanden, jedoch unter einem ungünstigeren Winkel im Vergleich zur nicht gedrehten Anlage nach der Korrespondenzfigur 3b. Um 12.00 Uhr mittags, also zu einer Zeit an der die nicht-verdrehte Anlage nach der Figur 3c ihre maximale Leistung erreicht, ist bei der verdrehten Anlage nach der Figur 5c die Leistung erst noch am Ansteigen, da die 30° Verdrehung nur schräg auf die PV-Module 11 einfallende Sonnenstrahlung bedingt. Die Leistungserzeugung verbessert sich kontinuierlich mir der wandernden Sonne bis drei Stunden später um 15.00 die Sonne etwas niedriger als mittags steht, dafür aber senkrecht auf die PV-Moduloberflächen auftrifft, so dass jetzt das Maximum der photovoltaisch erzeugten Leistung erreicht wird, wie es aus der Figur 5d ersichtlich ist. Beim weiteren Untergang der Sonne wird der Winkel immer günstiger sein als im nicht verdrehten Fall, so dass die Linie 3 aus der Figur 1 immer oberhalb der dortigen Linie 1 liegt. Spät am Abend setzt dann der Effekt der Abschattung bei tiefen abendlichen Sonnenständen ein, was in der Figur 5e durch die schraffierten Bereiche 13 angedeutet ist. Die Sonnenstrahlen sind dabei durch Pfeillinien 15 symbolisiert, deren Spitzen 17 den Auftreffpunkt der Strahlen auf die PV-Module 11 darstellt. Im abgeschatteten Bereich 13 sind entsprechend keine Spitzen vorhanden. Es ist selbstverständlich, dass die gewählten Tageszeiten und Auftreffwinkel allein zu Zwecken einer übersichtlichen Erläuterung gewählt wurden und nicht Bestandteil der vorliegenden technischen Lehre sind.

In den Figuren 6a bis 6d sind Beispiele von Photovoltaikmodulen 11 gezeigt, wie sie für den Einsatz bei vorliegender Erfindung geeignet sind. In der Figur 6a ist ein Modul 11 mit einer sogenannten TCO-Schicht als den elektrischen Kontak bildende Schicht zwischen den einzelnen Zellen gezeigt. Die einzelnen Zellen liegen dabei in Form von Streifen 19 vor, wobei die TCO-Schicht ebenfalls in Streifen über die gesamte Modulbreite- oder-länge geführt ist. Dies ist in der Nebenfigur 6A, die einen Querschnitt durch die Figur 6a widergibt ersichtlich. Die Streifen verlaufen senkrecht zur Richtung der Reihen 9, also von oben nach unten. Wird bei diesem Modultyp ein Bereich abgeschattet, so arbeiten die nicht abgeschatteten Bereiche weiter und ihre erzeugte Ladung wird ungehindert von den abgeschatteten Bereichen über die Kontaktschichten abgeführt und dem Wechselrichter zur Verfügung gestellt. Die Figur 6d zeigt den gleichen Sachverhalt mit parallel zu den Reihen 9 verlaufenden Streifen 19.

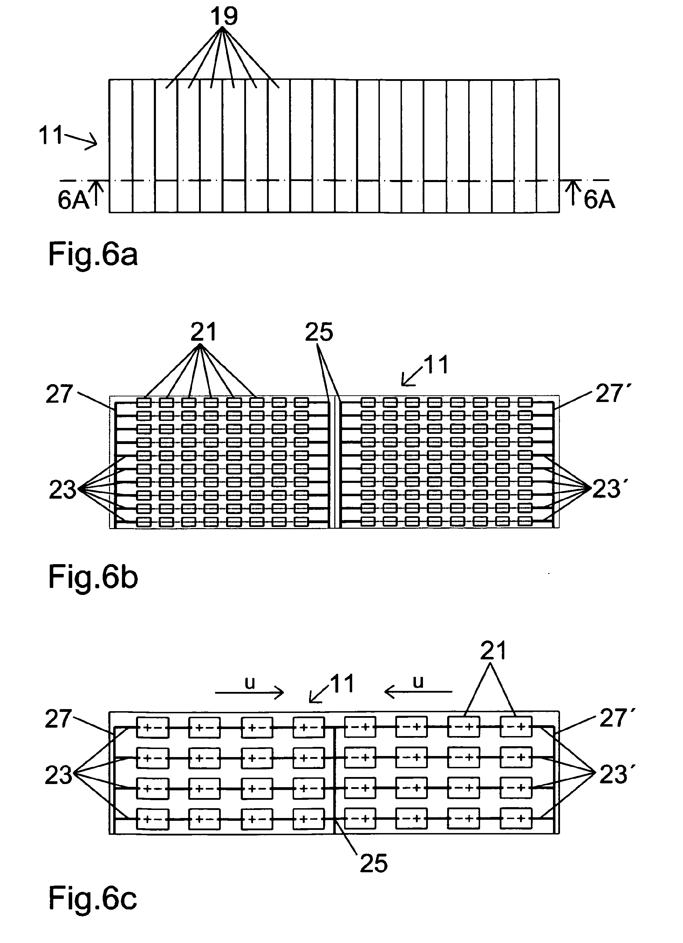

Die Figur 6b zeigt wie einzelne konventionelle Photovoltaikzellen 21 sich von Rand zu Rand des Photovoltaikmoduls 11 erstrecken. Sie bilden dabei Stränge 23, die parallel zur Richtung der Reihen 9 orientiert sind. Die Kontaktierung der Stränge 23 erfolgt an den beiden seitlichen Rändern des PV-Moduls 11. Im Ergebnis sind also die Photovoltaikzellen jedes Strangs 23 elektrisch in Serie und mehrere Stränge 23 eines Photovoltaikmoduls 11 elektrisch parallel geschaltet. Wird jetzt einer der Stränge 23 abgeschattet, so arbeiten die übrigen, nicht abgeschatteten Stränge 23 unverändert weiter. Eine Variation zu dieser Ausführungsform zeigt die Figur 6c. Dort sind auf dem PV-Modul 11 die Photovoltaikzellen 21 der Photovoltaikmodule 11 auf mehrere von Rand zu Rand verlaufende Stränge 23,23' aufgeteilt. Die Polorientierung in den gezeigten beiden Strangblöcken ist dabei gegeneinander gerichtet. So kann eine mittlere Kontaktelektrode 25 in Kooperation mit zwei randseitig angeordneten Randelektroden 27,27' jeweils die photovoltaisch erzeugte Gleichspannung U aufbauen.

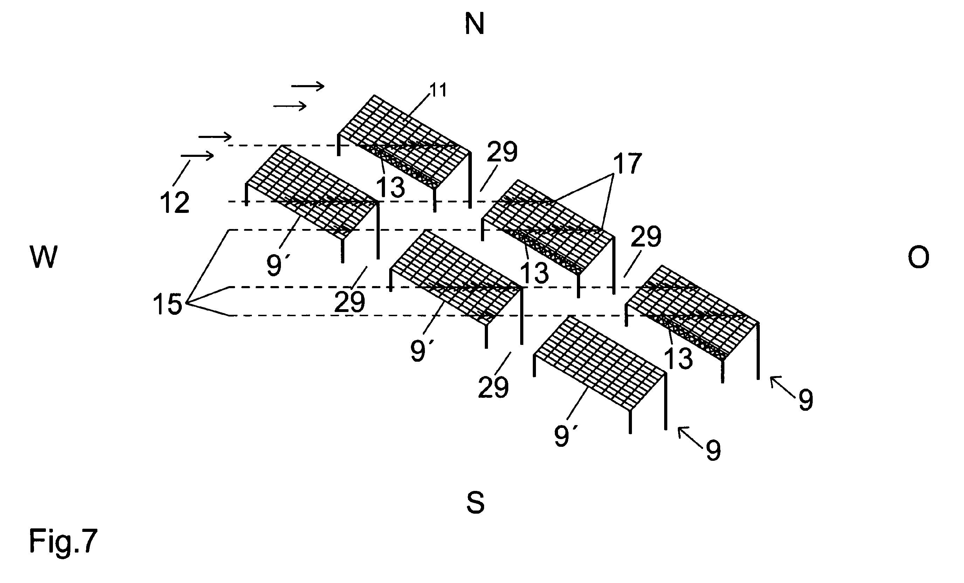

In der Figur 7 sind zwei hintereinander angeordnete Reihen 9 gezeigt, bei denen mittels Zwischenräumen 29 die jeweiligen Reihen 9 in Teilstücke oder Gruppen 9' gegliedert sind. Es ist ein später Sonnenstand analog zu der Figur 5e dargestellt, bei dem wiederum ein Schattenwurf auf die hinten liegende Reihe 9 mit einem kreuzschraffierten Bereich 13 symbolhaft angedeutet ist. Auch bei dieser Ausführungsform sind die Photovoltaikmodule nach den Figuren 6a bis 6c einsetzbar.

Es ist offensichtlich, das vorstehend ein Photovoltaikgenerator auf der Nordhalbkugel beschreiben ist. Ein auf der Südhalbkugel montierter PV-Generator ist dann entsprechend in Richtung Südost verdreht auszurichten.
Im Folgenden soll der Einsatz eines Mehrtarifzählers an einem Beispiel kurz erläutert werden. Es liegt ein einfacher, drei Tarifstufen umfassender Liefervertrag vor, der besagt, dass i) bei einer Einspeisung bis 12.00 Uhr mittags eine Vergütung von 5 Cent pro kWh erfolgt, ii) zwischen 12.00 und 16.00 ein Tarif von 20 Cent/kWh und iii) danach bis zum Abend ein Tarif von 10 Cent/kWh gültig ist. Unter i) sind 1 Megawatt erzeugt worden, was einer Minderleistung von 500.000 W entsprechen soll im Vergleich zu den möglichen 1,5 Megawatt, die erzeugt worden wären, wenn die Anlage gegen Süden ausgerichtet errichtet worden wäre. Es wird also ein Mindererlös von 500000 x 5 Cent = 25.000 Euro anfallen. Im Zeitbereich ii) ist hingegen eine Energiemenge von 1 '400.000 kWh erzeugt worden, was bei der konventionellen Ausrichtung lediglich 1'200.000 kWh geworden wären. Es wurde also eine Mehreinspeisung von 200.000 kWh im Vergleich zur konventionellen Ausrichtung erzielt. Diese 200.000 kWh mehr bedeuten aufgrund des höheren Tarifs von 20 Cent/kWh eine Mehreinnahme von 40.000 Euro. Obwohl insgesamt also 300.000 kWh weniger erzeugt wurden, wurde dennoch ein höherer Ertrag erzielt, da die Erzeugung zu einer "wertvolleren" Tageszeit anfiel. Gegen Abend zu während der Tarifspanne iii) kommt noch eine weitere Mehrerzeugung hinzu, weil der PV-Generator bis zum Sonnenuntergang besser auf die Sonne ausgerichtet bleibt. Das wirtschaftliche Ergebnis wird weiter verbessert.

### Bezugszeichenliste

- 1: dünne Linie
- 3: dicke Linie
- 5: dünn schraffierter Bereich
- 7: dick schraffierter Bereich
- 9: Reihe
- 9': Teilstück einer Reihe
- 11: PV-Modul
- 12: Richtungsvektor
- 13: kreuzschraffierter Bereich
- 15: Pfeillinie
- 17: Spitzen
- 19: Streifen
- 21: PV-Zelle
- 23, 23': Strang
- 25: mittlere Kontaktelektrode
- 27, 27': Randelektrode
- 29: Zwischenraum

## Patentansprüche

1. Freiflächenphotovoltaikgenerator mit einer Mehrzahl von geraden, parallel zueinander verlaufenden Reihen (9) von rechteckförmigen Photovoltaik-modulen (11), die auf einer fest stehenden Unterkonstruktion stationär angeordnet sind und jeweils einen einzigen Strang von in Serie geschalteter Photovoltaikzellen (19;21) umfassen, **dadurch gekennzeichnet, dass** die Photovoltaikzellen so auf jedem Photovoltaikmodul angeordnet sind, dass bei einer parallel zum unteren Rand des Photovoltaikmoduls verlaufenden Abschattung jede Photovoltaikzelle des Strangs die gleiche Abschattung erfährt, dass die Unterkonstruktion eine gleiche Neigung (α) aller Photovoltaikmodule zur Horizontalen bereitstellt und dass die Photovoltaik-module in einem Winkel (β) zwischen 10° und 40° in Richtung Südwest oder in Richtung Südost orientiert sind.

2. Freiflächenphotovoltaikgenerator mit einer Mehrzahl von geraden, parallel zueinander verlaufenden Reihen (9) von rechteckförmigen Photovoltaik-modulen (11), die auf einer fest stehenden Unterkonstruktion stationär angeordnet sind und jeweils mehrere Stränge von in Serie geschalteter Photovoltaikzellen (19;21) umfassen, deren Enden einen ersten und einen zweiten Ausgangspol des Photovoltaikmoduls bilden, dadurch gekenn-zeichnet, dass die Photovoltaikzellen so auf jedem Photovoltaikmodul angeordnet sind, dass bei einer parallel zum unteren Rand des Photovoltaik-moduls verlaufenden Abschattung alle Photovoltaikzellen desselben Stranges die gleiche Abschattung erfahren, dass die Unterkonstruktion eine gleiche Neigung (α) aller Photovoltaikmodule zur Horizontalen bereitstellt und dass die Photovoltaikmodule in einem Winkel (β) zwischen 10° und 40° in Richtung Südwest oder in Richtung Südost orientiert sind.

3. Freiflächenphotovoltaikgenerator mit einer Mehrzahl von geraden, parallel zueinander verlaufenden Reihen von durch einen Zwischenraum getrennten Gruppen von jeweils mehreren in Reihenrichtung verlaufenden, rechteck-förmigen Photovoltaikmodulen (11), die auf einer fest stehenden Unterkonstruktion stationär angeordnet sind und jeweils einen einzigen Strang von in Serie geschalteten Photovoltaikzellen (19;21) umfassen, **dadurch gekennzeichnet, dass** die Photovoltaikzellen so auf jedem Photovoltaikmodul angeordnet sind, dass zumindest bei einem Teil der Photovoltaikmodule einer Gruppe bei einer parallel zum unteren Rand des Photovoltaikmoduls verlaufenden Abschattung jede Photovoltaikzelle des Strangs die gleiche Abschattung erfährt, dass die Unterkonstruktion eine gleiche Neigung (α) aller Photovoltaikmodule zur Horizontalen bereitstellt und dass die Photovoltaik-module in einem Winkel (β) zwischen 10° und 40° in Richtung Südwest oder in Richtung Südost orientiert sind.

4. Freiflächenphotovoltaikgenerator mit einer Mehrzahl von geraden, parallel zueinander verlaufenden Reihen (9) von durch einen Zwischenraum getrennten Gruppen von jeweils mehreren in Reihenrichtung verlaufenden, rechteckförmigen Photovoltaikmodulen (11), die auf einer fest stehenden Unterkonstruktion stationär angeordnet sind und jeweils mehrere Stränge von in Serie geschalteter Photovoltaikzellen (19;21) umfassen, deren Enden einen ersten und einen zweiten Ausgangspol des Photovoltaikmoduls bilden, **dadurch gekennzeichnet, dass** die Photovoltaikzellen so auf jedem Photovoltaikmodul angeordnet sind, dass bei einer parallel zum unteren Rand des Photovoltaikmoduls verlaufenden Abschattung bei zumindest einem Teil der Photovoltaikmodule derselben Gruppe alle Photovoltaikzellen desselben Stranges die gleiche Abschattung erfahren, dass die Unterkonstruktion eine gleiche Neigung (α) aller Photovoltaikmodule zur Horizontalen bereitstellt und dass die Photovoltaikmodule in einem Winkel (β) zwischen 10° und 40° in Richtung Südwest oder in Richtung Südost orientiert sind.

5. Freiflächenphotovoltaikgenerator nach einem der Ansprüche 1 bis 4, **dadurch gekennzeichnet, dass** der Winkel (β) zwischen 15° und 35°, insbesondere zwischen 20° und 30° liegt.

6. Freiflächenphotovoltaikgenerator nach Anspruch 1 oder 3, **dadurch gekennzeichnet, dass** die Photovoltaikzellen von sich von Rand zu Rand der Photovoltaikmodule (11) erstreckenden Streifen (19) gebildet werden, wobei die Rand zu Rand Richtung senkrecht zur Richtung der Reihen (9) weist. (Fig. 6a)

7. Freiflächenphotovoltaikgenerator nach Anspruch 2 oder 4, **dadurch gekennzeichnet, dass** die Photovoltaikzellen (21) der Photovoltaikmodule (11) auf mehrere von Rand zu Rand verlaufende Stränge (23) aufgeteilt sind, wobei die Photovoltaikzellen jedes Strangs elektrisch in Serie und mehrere Stränge eines Photovoltaikmoduls elektrisch parallel geschaltet sind. (Fig. 6b)

8. Freiflächenphotovoltaikgenerator nach Anspruch 2 oder 4, **dadurch gekennzeichnet, dass** die Photovoltaikzellen (21) der Photovoltaikmodule (11) auf mehrere hintereinander angeordnete, parallel zu einem Rand verlaufende Stränge (23,23') aufgeteilt sind, wobei die Photovoltaikzellen jedes Strangs elektrisch in Serie und mehrere nebeneinander liegende Stränge eines Photovoltaikmoduls elektrisch parallel geschaltet sind. (Fig. 6c)

9. Freiflächenphotovoltaikgenerator nach einem der Ansprüche 1 bis 8, **dadurch gekennzeichnet, dass** er an ein Mehrtarifzählsystem angeschlossen ist, welches zu unterschiedlichen Tages- und/oder Jahreszeiten vorgebbare Tarife der erzeugten Energiemenge zuordnet.

10. Freiflächenphotovoltaikgenerator nach einem der Ansprüche 1 bis 9, **dadurch gekennzeichnet, dass** Reihen an Photovoltaikmodulen zwischen 10m und 500m, insbesondere zwischen 25 und 300 lang sind.
